# FASCICULE DE BREVET EUROPEEN

(11) **EP 1 352 422 B1**
(45) Date de publication et mention de la délivrance du brevet: **31.10.2018**
(21) Numéro de dépôt: 02711991.6
(22) Date de dépôt: 17.01.2002
(51) Int. Cl.: H01L 21/768

(54) **PROCEDE DE FABRICATION DE RESEAUX D'INTERCONNEXIONS**
VERFAHREN ZUR HERSTELLUNG VON VERBINDUNGSNETZWERKEN
METHOD FOR MAKING INTERCONNECTION NETWORKS

(30) Priorité: 18.01.2001 FR 0100680
(43) Date de publication de la demande: 15.10.2003
(73) Titulaire: STMicroelectronics S.A., 92120 Montrouge (FR); Commissariat à l'Énergie Atomique et aux Énergies Alternatives, 75015 Paris (FR)
(72) Inventeur: PASEMARD, Gérard, F-38660 Lumbin (FR); SICURANI, Emmanuel, F-38240 Meylan (FR); LECORNEC, Charles, F-38000 Grenoble (FR)
(74) Mandataire: Casalonga, Axel
(86) Numéro de dépôt international: PCT/FR2002/000186
(87) Numéro de publication internationale: WO 2002/058134

(56) Documents cités:
- EP-A- 1 096 562
- WO-A-01/54190
- WO-A2-00/07236
- US-A- 5 472 913
- US-A- 5 661 344
- US-A- 5 759 906
- US-A- 6 071 806
- "FIELD-EMISSION TRIODE INTEGRATED-CIRCUIT CONSTRUCTION METHOD" IBM TECHNICAL DISCLOSURE BULLETIN, IBM CORP. NEW YORK, US, vol. 32, no. 5B, 1 octobre 1989 (1989-10-01), pages 242-243, XP000049291 ISSN: 0018-8689
- YAU W-F ET AL: "BLACK DIAMOND-A LOW K DIELECTRIC FOR CU DAMASCENE APPLICATIONS", ADVANCED METALLIZATION CONFERENCE. PROCEEDINGS OF THE CONFERENCE, XX, XX, 28 September 1999 (1999-09-28), pages 379-386, XP001122264,

## Description

La présente invention concerne un procédé de fabrication de réseaux d'interconnexions, et concerne plus particulièrement les interconnexions en cuivre obtenues par le procédé dit Damascène.

Les structures d'interconnexions pour les circuits intégrés sont conventionnellement réalisées en Aluminium dopé entre 2 et 4% en cuivre. Le procédé employé consiste dans ce cas à déposer le métal, puis à le graver pour former le réseau d'interconnexions et enfin à déposer par-dessus le diélectrique qui servira à isoler aussi bien latéralement les lignes que verticalement les niveaux de métal.

Pour améliorer les performances des circuits, notamment en matière de vitesse et de consommation, on utilise des interconnexions en cuivre. En effet, grâce à la résistivité faible du cuivre, qui est presque deux fois moindre que celle de l'aluminium dopé en cuivre, ces interconnexions permettent de réduire les résistances Rᵢₙₜ. Un inconvénient de cette solution est que le cuivre se grave très difficilement.

On a donc développé un procédé, dit Damascène, permettant de se passer entièrement de la gravure du métal.

Selon le procédé Damascène, comme décrit dans la demande de brevet FR 2794286, on grave d'abord des tranchées dans un diélectrique généralement poreux de faible constante diélectrique, puis on dépose une barrière de diffusion en métal ou en nitrure métallique (par exemple Ta, Ti, TiN, TaN) en une couche tapissant les parois de ces tranchées, puis on dépose le métal d'interconnexion dans les tranchées. Enfin on "rabote" le cuivre de la surface du diélectrique par un polissage mécano-chimique (CMP), de manière à ne laisser du métal que dans les tranchées.

Cependant, lors du dépôt des barrières métalliques puis du métal dans les tranchées gravées dans le matériau diélectrique, le métal peut diffuser plus ou moins profondément dans les porosités ouvertes de celui-ci.

On dénature ainsi rapidement le matériau qui perd alors son rôle d'isolant. En outre, du fait de la miniaturisation des composants électroniques, les lignes métalliques sont de plus en plus rapprochées avec une distance moyenne entre elles de l'ordre de 0,1 *µ*m. Ces dimensions réduites et la dégradation du matériau diélectrique conduisent à un risque de formation de courts-circuits et à une dégradation de la capacité latérale entre deux lignes métalliques. Ces manifestations nuisent aux bonnes performances des composants électroniques réalisés.

Des procédés de fabrication des réseaux d'interconnexions sont également connus des documents WO 00/07236 A2 et US 5 661 344 A.

Les documents WO 01/54190 A (publié le 26.07.2001) et EP 1 096 562 A (publié le 02.05.2001) divulguent des structures d'interconnexion avec des couches de remplissage à faible constante diélectrique.

Le document "BLACK DIAMOND-A LOW K DIELECTRIC FOR CU DAMASCENE APPLICATIONS" (ADVANCED METALLIZATION CONFERENCE, 28 septembre 1999) divulgue des matériaux de type "Black Diamond" à faible constante diélectrique utilisés pour la fabrication des réseaux d'interconnexions.

On a ainsi envisagé, tel que décrit dans le document Texas Instruments "MRS Proc. Vol 511 p.213", de boucher les porosités ouvertes du matériau diélectrique à l'aide d'une couche d'oxyde de silicium. Mais avec un oxyde de silicium conventionnel déposé par PECVD (Plasma Enhanced Chemical Vapour Déposition en anglais), le dépôt du métal ne peut s'effectuer proprement, du fait de l'inhomogénéité de la couche de silice. Un autre inconvénient lié au dépôt d'une couche d'oxyde est la dégradation de la capacité latérale entre deux lignes métalliques, entraînant une capacité parasite, du fait de la constante diélectrique élevée, environ 4, de l'oxyde.

La présente invention propose un procédé de fabrication d'un réseau d'interconnexions remédiant à ces inconvénients.

En particulier, la présente invention propose un procédé de fabrication d'un réseau d'interconnexions qui réduit la diffusion de métal dans les porosités ouvertes du matériau diélectrique, permettant ainsi de diminuer la formation de courts-circuits et des effets induits d'une ligne du réseau sur l'autre.

L'invention propose un procédé de fabrication selon la revendication 1.

Le procédé peut comprendre les étapes successives suivantes :
a) le dépôt du matériau de remplissage
b) le dépôt d'une barrière de diffusion dans les tranchées
c) le dépôt du métal d'interconnexion.

Les tranchées sont formées dans au moins une couche de matériau diélectrique.

De préférence, les tranchées sont formées dans deux couches de matériau diélectrique.

Le procédé est particulièrement bien adapté à la réalisation de structures double Damascène. Le procédé peut ainsi comprendre les étapes successives suivantes :
(a) formation d'une première couche de matériau diélectrique,
(b) dépôt sur la première couche de matériau diélectrique d'une couche d'arrêt,
(c) gravure de la première couche de matériau diélectrique pour former une tranchée,
(d) dépôt d'une deuxième couche de matériau diélectrique,
(e) gravure de la deuxième couche de matériau diélectrique,
(f) dépôt d'un matériau de remplissage de manière à remplir les porosités ouvertes des deux couches de matériau diélectrique,
(g) retrait du matériau de remplissage, excepté dans les porosités ouvertes des deux couches de matériau diélectrique, cette étape étant facultative,
(h) dépôt d'une barrière de diffusion,
(i) dépôt d'un métal d'interconnexion.

Le matériau de remplissage peut être retiré, excepté dans les porosités ouvertes du matériau diélectrique.

Le matériau de remplissage est un polymère.

Selon une mise en oeuvre préférentielle du procédé de l'invention, le polymère est un polymère aromatique, par exemple de type polyaryléther, ou encore un polymère aromatique thermostable.

Le métal d'interconnexion peut comprendre du cuivre.

Le matériau de remplissage est non poreux.

Le matériau de remplissage a de préférence une température de décomposition ou de fusion supérieure à 450 °C. Sa constante diélectrique est comprise entre 2,5 et 3,5. Plus particulièrement, on choisira un polymère dont la constante diélectrique est comprise entre 2,6 et 2,8. En outre, le matériau de remplissage selon l'invention peut présenter une bonne capacité de remplissage. Ainsi, il peut notamment être capable de remplir des porosités de taille inférieure à 100 nm, de préférence inférieure à 20 nm, et encore de préférence inférieure à 10 nm.

Selon des exemples, le matériau de remplissage peut être déposé de différentes façons classiques. On peut envisager un dépôt par CVD (Chemical Vapour Déposition en anglais) ou par centrifugation. Toutefois, selon une variante particulièrement avantageuse du procédé de l'invention, le matériau de remplissage est sous forme dispersée et est déposé par centrifugation. Dans un mode de réalisation préféré, le dépôt obtenu est ensuite réticulé.

Le matériau de remplissage peut ensuite être retiré des tranchées. On peut envisager un retrait à l'aide d'un plasma oxydant anisotrope directionnel, laissant ainsi les pores du matériau poreux de faible constante diélectrique obstrués.

Selon une mise en oeuvre préférentielle du procédé de l'invention, la structure obtenue à ce stade du procédé est soumise à une étape de nettoyage, par exemple par spray ou par trempage.

Le procédé selon l'invention est alors poursuivi de manière classique par le dépôt d'une barrière de diffusion et d'un métal d'interconnexion. De préférence, le métal d'interconnexion comprend du cuivre.

L'invention concerne également un dispositif semi-conducteur selon la revendication 13.

Le dispositif semi-conducteur peut notamment présenter une structure double Damascène.

Le procédé selon l'invention est bien approprié pour la réalisation d'interconnexions en structure simple Damascène ou double Damascène à plusieurs niveaux de métal.

D'autres avantages et caractéristiques de l'invention apparaîtront à l'examen de la description détaillée d'un mode de mise en oeuvre nullement limitatif du procédé de l'invention.

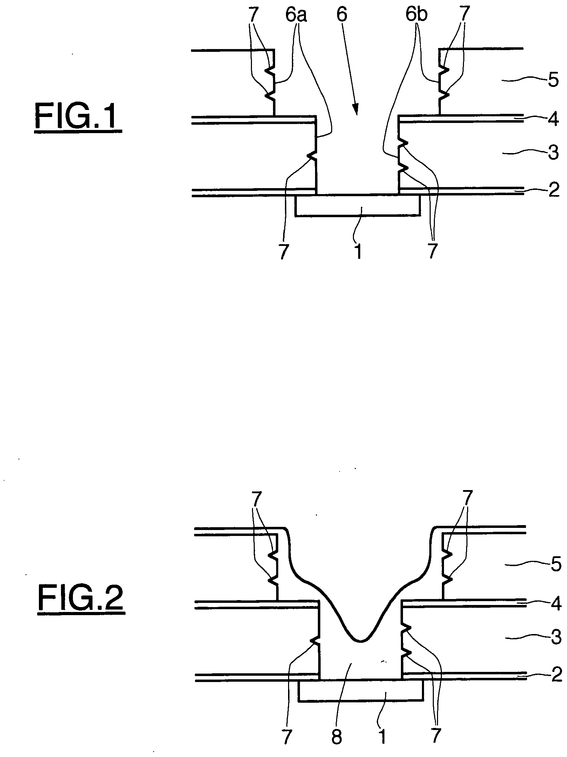

La suite de la description se réfère aux figures 1 à 4 et aux étapes principales du procédé de fabrication d'un réseau d'interconnexions en structure double Damascène à un niveau de métal selon ce mode de mise en oeuvre du procédé de l'invention.

Les figures 1 à 4 sont des coupes transversales du dispositif d'interconnexion illustrant les différentes étapes du procédé de fabrication de l'invention.

La figure 1 montre un plot métallique 1 sur une plaquette non référencée. Le métal utilisé est un métal usuel d'interconnexion, tel que le cuivre, l'aluminium, le tungstène. Toutefois, le procédé de l'invention est particulièrement adapté pour la réalisation d'interconnexions comprenant du cuivre.

On dépose successivement sur ce plot métallique 1 une couche barrière 2 et une couche 3 de matériau diélectrique appelée ILD (Inter-Layer Dielectric en anglais). La couche barrière 2 peut être par exemple un diélectrique minéral.

On dépose ensuite sur la couche 3 une couche d'arrêt 4, puis on grave la couche 3 pour réaliser des tranchées 6. Les tranchées 6 présentent des parois 6a et 6b, généralement perpendiculaires à la surface supérieure de la couche d'arrêt 4. Puis on procède au dépôt d'une couche 5 de matériau diélectrique appelée IMD (Inter-Metal Dielectric en anglais). Ce dépôt est suivi d'une gravure des couches 3 et 5, par exemple par une gravure sèche au fluor.

Dans le procédé double Damascène, on utilise généralement le même matériau diélectrique de faible constante diélectrique pour réaliser les couches 3 et 5. On entend par matériau diélectrique de faible constante diélectrique un matériau dont la constante diélectrique est inférieure à 4. Le matériau peut être poreux, voire mésoporeux avec une taille moyenne des pores inférieure à 10 nm, voire comprise entre 3 et 6 nm avec une distribution prise entre 1 et 20 nm.

Ce matériau diélectrique peut être minéral, organique ou hybride. A titre d'exemple, on peut citer le méthyl sisesquioxane poreux, le xérogel, ou autres matériaux minéraux à structure poreuse. On préférera le xérogel dont la constante diélectrique est de l'ordre de 2.

On dépose ensuite sur la couche 5 ainsi que sur les parois 6a et 6b des tranchées 6, préalablement au dépôt d'une barrière de diffusion 9, un matériau de remplissage 8 (voir figure 2).

En effet, il s'avère que les parois 6a et 6b des tranchées 6 présentent un certain nombre de porosités ouvertes 7 que le matériau de remplissage 8 est apte à combler.

Selon une variante de l'invention, le matériau de remplissage 8 est thermostable. Sa température de décomposition ou de fusion est de préférence supérieure à 450°C, afin notamment de supporter les éventuels recuits lors de la fabrication des composants électroniques.

Le matériau de remplissage 8 est non poreux, bien qu'il puisse, en vue de l'obtention d'une faible constante diélectrique, présenter un certain volume libre. Par non poreux, on entend que sa porosité empêche la diffusion du métal d'interconnexion et/ou du métal de la barrière métallique dans les porosités ouvertes du diélectrique.

Le matériau de remplissage 8 présente une faible constante diélectrique afin d'éviter de trop grandes interactions entre les lignes métalliques du réseau souvent espacées de seulement environ 0,1 *µ*m. On utilise des matériaux de remplissage 8 ayant une constante diélectrique comprise entre 2,5 et 3,5. Plus particulièrement, on choisira un matériau de remplissage 8 de constante diélectrique comprise entre 2,6 et 2,8.

Outre ces caractéristiques, le matériau de remplissage 8 peut également posséder une bonne capacité de remplissage, afin de pouvoir combler les porosités ouvertes 7 des couches 3 et 5 du matériau diélectrique, de taille très inférieure à 100 nm. En effet, la taille des pores des diélectriques utilisés peut atteindre 20 nm, voire 10 nm.

Par ailleurs, il est préférable que le matériau de remplissage 8 soit compatible avec le dépôt ultérieur d'une barrière de diffusion 9, c'est-à-dire qu'il n'y ait pas de dégradation induite par le dépôt PVD (Physical Vapour Déposition en anglais) ou CVD (Chemical Vapour Déposition en anglais) de la barrière de diffusion 9. En outre, du fait d'un dépôt possible de la barrière de diffusion 9 par CVD, il est préférable que le matériau de remplissage 8 soit chimiquement stable.

Le matériau de remplissage 8 peut être organique, minéral ou hybride.

A titre de matériaux de remplissage particulièrement préférés, on peut citer les polymères aromatiques, éventuellemnt thermostables. Ainsi, on peut utiliser le polymère dénommé SILK commercialisé par la société DOW CHEMICAL, le polymère dénommé FLARE commercialisé par la société HONEYWELL, qui sont des polymères non poreux aromatiques de constante diélectrique de l'ordre de 2,7.

Le matériau de remplissage 8 peut être déposé de différentes manières. A titre d'exemple, on peut envisager un dépôt par CVD ou un dépôt par centrifugation.

On préfère toutefois, lorsque cela est possible, le dépôt par centrifugation, notamment lorsque le matériau de remplissage 8 est un polymère. En effet, le dépôt par CVD s'effectue par croissance du matériau de remplissage 8 sur les parois des tranchées 6. Etant données les dimensions des tranchées 6, il y a un risque de formation d'un bouchon avant que le matériau de remplissage 8 n'ait pu remplir les porosités ouvertes 7 des couches 3 et 5 de matériau diélectrique. Ce risque est supprimé avec un dépôt par centrifugation.

Si on dépose le matériau de remplissage 8 par centrifugation, celui-ci se présente sous forme d'une dispersion en phase. On dépose alors sur le dispositif une goutte du matériau de remplissage 8. Par centrifugation, cette goutte va s'étaler et couler dans les tranchées 6, puis combler les porosités ouvertes 7 des couches 3 et 5 de matériau diélectrique. Cette étape est réalisée en un temps suffisant pour combler la totalité de la structure poreuse ouverte des couches 3 et 5 de matériau diélectrique.

Le matériau de remplissage 8, une fois déposé par centrifugation, est ensuite réticulé afin de le rendre stable. La réticulation peut s'effectuer par diverses méthodes. On peut envisager un traitement thermique à une température de l'ordre de 400°C, ou à une température inférieure. On veille alors à ne pas dépasser la température de décomposition ou de fusion du matériau de remplissage 8. On peut également envisager une réticulation par traitement aux rayons UV ou encore sous faisceau d'électrons.

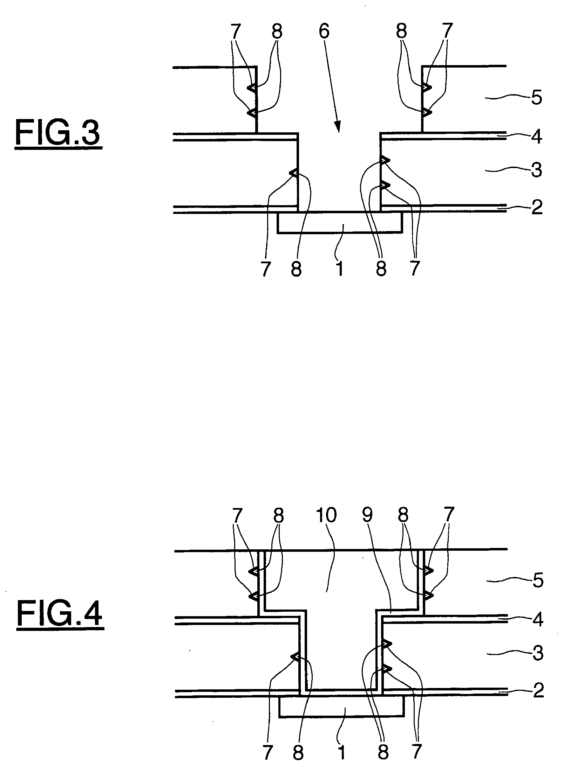

Le matériau de remplissage 8 est ensuite retiré de la surface de la structure Damascène, excepté dans les porosités ouvertes 7 des couches 3 et 5 de matériau diélectrique. Ce retrait peut s'effectuer par gravure anisotrope à l'aide d'un plasma oxydant. La figure 3 montre la structure Damascène à cette étape du procédé, les porosités ouvertes 7 des couches 3 et 5 de matériau diélectrique étant remplies par le matériau de remplissage 8 réticulé.

L'étape de gravure du matériau de remplissage 8 peut entraîner une pulvérisation du métal 1 sur les parois des tranchées 6. Afin d'éliminer ces salissures, on peut soumettre la plaquette à une étape de nettoyage, par exemple liquide. Cette étape permet également de supprimer les traces de matériau de remplissage 8 ayant été éventuellement formées lors de l'étape de gravure.

Pour compléter le procédé, on dépose une barrière de diffusion métallique 9 puis un métal d'interconnexion 10 dans les tranchées 6 du dispositif semi-conducteur (voir figure 4).

Le procédé présente un avantage supplémentaire. Traditionnellement, lors de la recristallisation du métal, les grains du métal croissent latéralement et peuvent dégrader la structure. L'association entre le matériau de remplissage 8 et le matériau diélectrique a pour avantage de consolider latéralement cette structure en la rendant moins friable.

On retire ensuite l'excès de métal d'interconnexion 10 de la surface de la couche 5 de matériau diélectrique par un polissage mécano-chimique.

La figure 4 montre le dispositif semi-conducteur en fin du procédé Damascène. Au-dessus du plot métallique 1 se trouve la couche barrière 2, au-dessus de laquelle il y a la couche 3 de matériau diélectrique.

Sur la couche 3, se trouve la couche d'arrêt 4, et sur la couche d'arrêt 4, la couche 5 de matériau diélectrique. Les porosités ouvertes 7 du matériau diélectrique sont comblées par le matériau de remplissage 8. Le matériau de remplissage 8, Les tranchées 6 sont remplies par la barrière de diffusion 9 et le métal d'interconnexion 10.

Le dispositif semi-conducteur ainsi réalisé avec des interconnexions Damascène peut avantageusement servir de dispositif de base à la réalisation de nouveaux circuits intégrés dont les performances seront améliorées puisque le risque de court-circuit, du fait de la diffusion métallique dans la structure poreuse du diélectrique des couches ILD et IMD, est réduit. En outre, en incorporant le matériau de remplissage 8 de faible constante diélectrique, on diminue la capacité latérale entre deux lignes métalliques du dispositif semi-conducteur. Ce faisant, on réduit les effets induits d'une ligne sur l'autre.

## Revendications

1. Procédé de fabrication d'un réseau d'interconnexions comprenant le dépôt d'un métal d'interconnexion (10) dans lequel, préalablement au dépôt du métal d'interconnexion (10), on dépose dans des tranchées (6) formées dans au moins une couche (3,5) de matériau diélectrique, un matériau de remplissage (8), de manière à remplir des porosités ouvertes (7) dudit matériau diélectrique, ledit matériau de remplissage (8) étant destiné à empêcher la diffusion ultérieure du métal d'interconnexion (10) et/ou d'un métal d'une barrière de diffusion (9), ledit matériau de remplissage (8) étant non poreux
**caractérisé en ce que** ledit matériau de remplissage (8) a une constante diélectrique comprise entre 2,5 et 3,5 et **en ce que** ledit matériau de remplissage (8) est un polymère.

2. Procédé selon la revendication 1, comprenant les étapes successives suivantes :
a) le dépôt du matériau de remplissage (8),
b) le dépôt d'une barrière de diffusion (9) dans les tranchées (6),
c) le dépôt du métal d'interconnexion (10).

3. Procédé selon l'une quelconque des revendications précédentes, **caractérisé en ce que** les tranchées sont formées dans deux couches (3,5) de matériau diélectrique.

4. Procédé selon la revendication 3, comprenant les étapes successives suivantes :
a) formation d'une première couche (3) de matériau diélectrique,
b) dépôt sur la première couche (3) de matériau diélectrique d'une couche d'arrêt (4),
c) gravure de la première couche (3) de matériau diélectrique pour former une tranchée (6),
d) dépôt d'une deuxième couche (5) de matériau diélectrique,
e) gravure de la deuxième couche (5) de matériau diélectrique,
f) dépôt d'un matériau de remplissage (8) de manière à remplir les porosités ouvertes (7) des deux couches (3,5) de matériau diélectrique,
g) retrait du matériau de remplissage (8), excepté dans les porosités ouvertes (7) des deux couches (3,5) de matériau diélectrique,
h) dépôt d'une barrière de diffusion (9),
i) dépôt d'un métal d'interconnexion (10).

5. Procédé selon l'une quelconque des revendications 1 à 3, **caractérisé en ce que** le matériau de remplissage (8) est retiré, excepté dans les porosités ouvertes (7) du matériau diélectrique.

6. Procédé selon l'une quelconque des revendications précédentes, **caractérisé en ce que** le matériau de remplissage (8) est un polymère aromatique, éventuellement thermostable

7. Procédé selon l'une quelconque des revendications précédentes, **caractérisé en ce que** le métal d'interconnexion (10) comprend du cuivre.

8. Procédé selon l'une quelconque des revendications précédentes, **caractérisé en ce que** le matériau de remplissage (8) a une température de décomposition ou de fusion supérieure à 450 °C.

9. Procédé selon l'une quelconque des revendications précédentes, **caractérisé en ce que** le matériau de remplissage (8) a une constante diélectrique comprise entre 2,6 et 2,8.

10. Procédé selon l'une quelconque des revendications précédentes, **caractérisé en ce que** le matériau de remplissage (8) est capable de remplir des porosités ouvertes (7) de taille inférieure à 100 nm, de préférence inférieures à 20 nm, et encore de préférence inférieures à 10 nm.

11. Procédé selon l'une quelconque des revendications précédentes, **caractérisé en ce que** le matériau de remplissage (8) est déposé par centrifugation.

12. Procédé selon l'une quelconque des revendications précédentes, **caractérisé en ce que** le matériau de remplissage (8) est réticulé, une fois déposé.

13. Dispositif semi-conducteur comprenant un réseau d'interconnexions comprenant au moins une couche (3,5) de matériau diélectrique, et au moins une ligne d'interconnexion ou au moins un via d'interconnexion formés dans une tranchée (6), le matériau diélectrique présentant des porosités ouvertes (7), le dispositif comprend un matériau de remplissage (8) desdites porosités ouvertes (7), ledit matériau de remplissage (8) étant disposé entre le matériau diélectrique et les vias ou les lignes d'interconnexion, et ledit matériau de remplissage étant non poreux
**caractérisé en ce que** ledit matériau de remplissage (8) a une constante diélectrique comprise entre 2,5 et 3,5 et **en ce que** ledit matériau de remplissage (8) est un polymère.

14. Dispositif semi-conducteur selon la revendication 13, **caractérisé en ce que** le dispositif comprend deux couches (3,5) de matériau diélectrique.

15. Dispositif selon la revendication 14, **caractérisé en ce que** le dispositif comprend :
a) un matériau de remplissage (8) des porosités ouvertes (7) des parois (6a, 6b) d'une tranchée (6) formée dans les deux couches (3,5) de matériau diélectrique, ledit matériau de remplissage (8) étant situé dans lesdites porosités ouvertes (7),
b) une barrière de diffusion (9) et/ou un métal d'interconnexion (10), remplissant la tranchée (6).

16. Dispositif semi-conducteur selon l'une quelconque des revendications 13 à 15, **caractérisé en ce que** le réseau d'interconnections est réalisé à base de cuivre.

17. Dispositif semi-conducteur selon la revendication 13 ou 14, **caractérisé en ce que** le matériau de remplissage (8) est situé dans les porosités ouvertes des parois (6a,6b) de la tranchée (6).

18. Dispositif semi-conducteur selon l'une quelconque des revendications 13 à 17, **caractérisé en ce que** le matériau de remplissage (8) est un polymère aromatique, éventuellement thermostable.

19. Dispositif semi-conducteur selon l'une quelconque des revendications 13 à 18, **caractérisé en ce que** le matériau de remplissage (8) a une température de décomposition ou de fusion supérieure à 450 °C.

20. Dispositif semi-conducteur selon l'une quelconque des revendications 13 à 19, **caractérisé en ce que** le matériau de remplissage (8) a une constante diélectrique comprise entre 2,6 et 2,8.

21. Dispositif semi-conducteur selon l'une quelconque des revendications 13 à 20, **caractérisé en ce que** le matériau de remplissage (8) est capable de remplir des porosités ouvertes (7) de taille inférieure à 100 nm, de préférence inférieures à 20 nm, et encore de préférence inférieures à 10 nm.

## Patentansprüche

1. Verfahren zum Herstellen eines Querverbindungsnetzes, das das Ablagern eines Querverbindungsmetalls (10) umfasst, wobei vor dem Ablagern des Querverbindungsmetalls (10) in Gräben (6), die in wenigstens einer Schicht (3, 5) aus dielektrischem Material gebildet sind, ein Füllmaterial (8) abgelagert wird, derart, dass offene Porositäten (7) des dielektrischen Materials gefüllt werden, wobei das Füllmaterial (8) dazu bestimmt ist, die spätere Diffusion des Querverbindungsmetalls (10) und/oder eines Metalls einer Diffusionssperre (9) zu verhindern, wobei das Füllmaterial (8) nicht porös ist,
**dadurch gekennzeichnet, dass** das Füllmaterial (8) eine Dielektrizitätskonstante im Bereich von 2,5 bis 3,5 besitzt und dass das Füllmaterial (8) ein Polymer ist.

2. Verfahren nach Anspruch 1, das die folgenden aufeinander folgenden Schritte umfasst:
a) Ablagern des Füllmaterials (8),
b) Ablagern einer Diffusionssperre (9) in den Gräben (6),
c) Ablagern des Querverbindungsmetalls (10).

3. Verfahren nach einem der vorhergehenden Ansprüche, **dadurch gekennzeichnet, dass** die Gräben in zwei Schichten (3, 5) aus dielektrischem Material gebildet sind.

4. Verfahren nach Anspruch 3, das die folgenden aufeinander folgenden Schritte umfasst:
a) Bilden einer ersten Schicht (3) aus dielektrischem Material,
b) Ablagern auf der ersten Schicht (3) aus dielektrischem Material einer Sperrschicht (4),
c) Ätzen der ersten Schicht (3) aus dielektrischem Material, um einen Graben (6) zu bilden,
d) Ablagern einer zweiten Schicht (5) aus dielektrischem Material,
e) Ätzen der zweiten Schicht (5) aus dielektrischem Material,
f) Ablagern eines Füllmaterials (8) in der Weise, dass die offenen Porositäten (7) der beiden Schichten (3, 5) aus dielektrischem Material gefüllt werden,
g) Verringern des Füllmaterials (8) außerhalb der offenen Porositäten (7) der beiden Schichten (3, 5) aus dielektrischem Material,
h) Ablagern einer Diffusionssperre (9),
i) Ablagern eines Querverbindungsmetalls (10).

5. Verfahren nach einem der Ansprüche 1 bis 3, **dadurch gekennzeichnet, dass** das Füllmaterial (8) außerhalb der offenen Porositäten (7) des dielektrischen Materials entfernt wird.

6. Verfahren nach einem der vorhergehenden Ansprüche, **dadurch gekennzeichnet, dass** das Füllmaterial (8) ein aromatisches, eventuell thermostabiles Polymer ist.

7. Verfahren nach einem der vorhergehenden Ansprüche, **dadurch gekennzeichnet, dass** das Querverbindungsmetall (10) Kupfer enthält.

8. Verfahren nach einem der vorhergehenden Ansprüche, **dadurch gekennzeichnet, dass** das Füllmaterial (8) eine Zerlegungs- oder Schmelztemperatur von mehr als 450 °C besitzt.

9. Verfahren nach einem der vorhergehenden Ansprüche, **dadurch gekennzeichnet, dass** das Füllmaterial (8) eine Dielektrizitätskonstante im Bereich von 2,6 bis 2,8 besitzt.

10. Verfahren nach einem der vorhergehenden Ansprüche, **dadurch gekennzeichnet, dass** das Füllmaterial (8) offene Porositäten (7) mit einer Größe von weniger als 100 nm, vorzugsweise weniger als 20 nm und noch stärker bevorzugt weniger als 10 nm füllen kann.

11. Verfahren nach einem der vorhergehenden Ansprüche, **dadurch gekennzeichnet, dass** das Füllmaterial (8) durch Zentrifugieren abgelagert wird.

12. Verfahren nach einem der vorhergehenden Ansprüche, **dadurch gekennzeichnet, dass** das Füllmaterial (8) vernetzt wird, sobald es abgelagert ist.

13. Halbleitervorrichtung, die ein Querverbindungsnetz umfasst, das wenigstens eine Schicht (3, 5) aus dielektrischem Material und wenigstens eine Querverbindungsleitung oder wenigstens ein Querverbindungskontaktloch, die in einem Graben (6) gebildet sind, enthält, wobei das dielektrische Material offene Porositäten (7) aufweist, wobei die Vorrichtung ein Füllmaterial (8) für die offenen Porositäten (7) umfasst, wobei das Füllmaterial (8) zwischen dem dielektrischen Material und den Querverbindungskontaktlöchern oder -leitungen angeordnet ist, wobei das Füllmaterial nicht porös ist,
**dadurch gekennzeichnet, dass** das Füllmaterial (8) eine Dielektrizitätskonstante im Bereich von 2,5 bis 3,5 besitzt und dass das Füllmaterial (8) ein Polymer ist.

14. Halbleitervorrichtung nach Anspruch 13, **dadurch gekennzeichnet, dass** die Vorrichtung zwei Schichten (3, 5) aus dielektrischem Material umfasst.

15. Vorrichtung nach Anspruch 14, **dadurch gekennzeichnet, dass** die Vorrichtung Folgendes umfasst:
a) ein Material (8) zum Befüllen offener Porositäten (7) der Wände (6a, 6b) eines Grabens (6), der in den beiden Schichten (3, 5) aus dielektrischem Material gebildet ist, wobei sich das Füllmaterial (8) in den offenen Porositäten (7) befindet.
b) eine Diffusionssperre (9) und/oder ein Querverbindungsmetall (10), die den Graben (6) füllen.

16. Halbleitervorrichtung nach einem der Ansprüche 13 bis 15, **dadurch gekennzeichnet, dass** das Querverbindungsnetz auf Kupferbasis hergestellt ist.

17. Halbleitervorrichtung nach Anspruch 13 oder 14, **dadurch gekennzeichnet, dass** sich das Füllmaterial (8) in den offenen Porositäten der Wände (6a, 6b) des Grabens (6) befindet.

18. Halbleitervorrichtung nach einem der Ansprüche 13 bis 17, **dadurch gekennzeichnet, dass** das Füllmaterial (8) ein aromatisches, eventuell thermostabiles Polymer ist.

19. Halbleitervorrichtung nach einem der Ansprüche 13 bis 18, **dadurch gekennzeichnet, dass** das Füllmaterial (8) eine Zerlegungs- oder Schmelztemperatur von mehr als 450 °C besitzt.

20. Halbleitervorrichtung nach einem der Ansprüche 13 bis 19, **dadurch gekennzeichnet, dass** das Füllmaterial (8) eine Dielektrizitätskonstante im Bereich von 2,6 bis 2,8 besitzt.

21. Halbleitervorrichtung nach einem der Ansprüche 13 bis 20, **dadurch gekennzeichnet, dass** das Füllmaterial (8) offene Porositäten (7) mit einer Größe von weniger als 100 nm, vorzugsweise weniger als 20 nm und noch stärker bevorzugt weniger als 10 nm füllen kann.

## Claims

1. Method of fabricating an interconnect network comprising the deposition of an interconnect metal (10), in which, prior to the deposition of the interconnect metal (10), a filler material (8) is deposited in trenches (6) formed in at least one layer (3,5) of dielectric material, in such a manner as to fill in open porosities (7) of the said dielectric material, the said filler material (8) being designed to prevent the later diffusion of the interconnect metal (10) and/or of a diffusion barrier metal (9), the said filler material (8) being non-porous
**characterized in that** the said filler material (8) has a dielectric constant in the range between 2.5 and 3.5 and **in that** the said filler material (8) is a polymer.

2. Method according to Claim 1, comprising the following successive steps:
a) the deposition of the filler material (8),
b) the deposition of a diffusion barrier (9) in the trenches (6),
c) the deposition of the interconnect metal (10) .

3. Method according to any one of the preceding claims, **characterized in that** the trenches are formed in two layers (3,5) of dielectric material.

4. Method according to Claim 3, comprising the following successive steps:
a) formation of a first layer (3) of dielectric material,
b) deposition onto the first layer (3) of dielectric material of a stopping layer (4),
c) etching of the first layer (3) of dielectric material so as to form a trench (6),
d) deposition of a second layer (5) of dielectric material,
e) etching of the second layer (5) of dielectric material,
f) deposition of a filler material (8) in such a manner as to fill in the open porosities (7) of the two layers (3,5) of dielectric material,
g) removal of the filler material (8), except in the open porosities (7) of the two layers (3,5) of dielectric material,
h) deposition of a diffusion barrier (9),
i) deposition of an interconnect metal (10).

5. Method according to any one of Claims 1 to 3, **characterized in that** the filler material (8) is removed, except in the open porosities (7) of the dielectric material.

6. Method according to any one of the preceding claims, **characterized in that** the filler material (8) is an aromatic polymer, potentially a thermostable polymer.

7. Method according to any one of the preceding claims, **characterized in that** the interconnect metal (10) comprises copper.

8. Method according to any one of the preceding claims, **characterized in that** the filler material (8) has a decomposition temperature or melting point higher than 450 °C.

9. Method according to any one of the preceding claims, **characterized in that** the filler material (8) has a dielectric constant in the range between 2.6 and 2.8.

10. Method according to any one of the preceding claims, **characterized in that** the filler material (8) is able to fill in open porosities (7) of size less than 100 nm, preferably less than 20 nm, or even more preferably less than 10 nm.

11. Method according to any one of the preceding claims, **characterized in that** the filler material (8) is deposited by centrifugation.

12. Method according to any one of the preceding claims, **characterized in that** the filler material (8), once deposited, is reticulated.

13. Semiconductor device comprising an interconnect network comprising at least one layer (3,5) of dielectric material, and at least one interconnect track or at least one interconnect via formed in a trench (6), the dielectric material having open porosities (7), the device comprises a material (8) for filling in the said open porosities (7), the said filler material (8) being deposited between the dielectric material and the vias or the interconnect tracks, and the said filler material being non-porous
**characterized in that** the said filler material (8) has a dielectric constant in the range between 2.5 and 3.5 and **in that** the said filler material (8) is a polymer.

14. Semiconductor device according to Claim 13, **characterized in that** the device comprises two layers (3,5) of dielectric material.

15. Semiconductor device according to Claim 14, **characterized in that** the device comprises:
a) a material (8) for filling in the open porosities (7) of the walls (6a, 6b) of a trench (6) formed in the two layers (3,5) of dielectric material, the said filler material (8) being situated within the open porosities (7),
b) a diffusion barrier (9) and/or an interconnect metal (10) filling the trench (6) .

16. Semiconductor device according to any one of Claims 13 to 15, **characterized in that** the interconnect network is formed of copper.

17. Semiconductor device according to either of Claims 13 and 14, **characterized in that** the filler material (8) is situated within the open porosities of the walls (6a, 6b) of the trench (6) .

18. Semiconductor device according to any one of Claims 13 to 17, **characterized in that** the filler material (8) is a polymer, potentially a thermostable polymer.

19. Semiconductor device according to any one of Claims 13 to 18, **characterized in that** the filler material (8) has a decomposition temperature or melting point higher than 450 °C.

20. Semiconductor device according to any one of Claims 13 to 19, **characterized in that** the filler material (8) has a dielectric constant in the range between 2.6 and 2.8.

21. Semiconductor device according to any one of Claims 13 to 20, **characterized in that** the filler material (8) is able to fill in open porosities (7) of size less than 100 nm, preferably less than 20nm, or even more preferably less than 10nm.
